# EUROPEAN PATENT APPLICATION

(11) **EP 4 513 671 A1**
(43) Date of publication of application: **26.02.2025**
(21) Application number: 24186021.2
(22) Date of filing: 02.07.2024
(51) Int. Cl.: H01Q 1/22, H01Q 5/385, H01Q 9/04, H01Q 13/10, H01Q 21/29, H05K 3/46, H01Q 1/32, H01Q 13/02, H01Q 15/08, H01Q 19/06, H01Q 21/00, H01Q 21/06, H01Q 13/18

(54) **COMPONENT CARRIER WITH SHIELDED CAVITY AND ANTENNA**

(30) Priority: 24.08.2023 WO PCT/EP2023/073222
(71) Applicant: AT & S Austria Technologie & Systemtechnik Aktiengesellschaft, 8700 Leoben-Hinterberg (AT)
(72) Inventor: TAKAHASHI, Hiroaki, 1090 Wien (AT); EBNER, Claudia, 8583 Edelschrott (AT); SCHLICK, Daniel, 8733 St. Marein-Feistritz (AT); TRISCHLER, Heinrich, 8063 Eggersdorf (AT); SCHLAFFER, Erich, 8642 St. Lorenzen (AT); ALOTHMAN ALTERKAWI, Ahmad Bader, 8020 Graz (AT)
(74) Representative: Donatello, Daniele

(57) **Abstract**

Component carrier (100) which comprises a stack (102) comprising a plurality of electrically conductive layer structures (150) and a plurality of electrically insulating layer structures (152), a cavity (104) formed in the stack (102), said cavity (104) being delimited by a peripheral wall, a conductive shielding (106) covering the peripheral wall of the cavity (104), and an antenna (108) formed as part of said stack (102), wherein the conductive shielding (106) has an opening (110) on a top extremity of said cavity (104) along a stack direction (112), said opening (110) being vertically associated with the antenna (108) provided on top of and/or at said opening (110).

## Description

The invention relates to a component carrier and to a method for dimensioning a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Moreover, artefacts may occur when high-frequency signals propagate along wiring structures of a component carrier. Such phenomena can substantially degrade the overall performance of a communication systems, etc.

It is an object of the invention to provide a component carrier with high performance, in particular in terms of high-frequency signal transmission.

In order to achieve the object defined above, a component carrier, and a method of dimensioning a component carrier according to the independent claims are provided.

According to an exemplary embodiment, a component carrier is provided which comprises a stack comprising a plurality of electrically conductive layer structures and a plurality of electrically insulating layer structures, a cavity formed in the stack, said cavity being delimited by a peripheral wall, a conductive shielding covering the peripheral wall of the cavity, and an antenna formed as part of said stack, wherein the conductive shielding has an opening on a top extremity of said cavity along a stack direction, said opening being vertically associated with the antenna provided on top of and/or at said opening.

According to another exemplary embodiment of the invention, a method for dimensioning a component carrier having the above mentioned features is provided, the method comprising decreasing a ratio between a height and a width of the cavity until a bandwidth of electromagnetic wave transmission meets a predefined bandwidth criterion, and/or increasing a ratio between a height and a width of the cavity until a return loss of electromagnetic wave transmission meets a predefined return loss criterion.

According to still another exemplary embodiment of the invention, a component carrier having the above-mentioned features is used for a high-frequency application, in particular for conducting a radio frequency (RF) signal, in particular a radio frequency signal with a frequency above 1 GHz or even above 50 GHz.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another.

In the context of the present application, the term "layer structure" may particularly denote a continuous layer, a patterned layer or a plurality of nonconsecutive islands within a common plane.

In the context of the present application, the term "cavity" may particularly denote a recess, groove or hole (in particular blind hole or through hole) extending up to and/or into the stack. Preferably, all the sides of the cavity may be defined by layer structures of the stack. The cavity may be configured to function as a waveguide, for example as an air-filled waveguide. In the context of the present application, the term "waveguide" may particularly denote a structure that guides waves, such as electromagnetic waves, with reduced loss of energy by restricting the transmission of energy to a limited number of directions, in particular, to one direction. Without the physical constraint of a waveguide, wave amplitudes decrease more quickly as they expand into the three dimensional space. For instance, a waveguide may be a hollow conductive recess in a layer stack of a component carrier which may be used to carry high frequency radio waves. For instance, a cross-section of a metallized recess (i.e. said cavity with conductive shielding) functioning as waveguide may be rectangular or circular. For example, a signal may be coupled with a waveguide using a stripline, i.e. a transverse electromagnetic transmission line such as a planar transmission line. Such a stripline may be provided at one side, for example the bottom, of the cavity. In particular, a signal may be coupled between waveguide and stripline at a waveguide-to-stripline transition. The stripline may be in direct contact with the waveguide or the stripline may be spatially spaced with regard to the waveguide. Furthermore at least one stripline, in particular a plurality of striplines, may be associated with the waveguide.

In the context of the present application, the term "conductive shielding" may particularly denote electrically conductive material (for example metal, such as copper, titanium, silver, palladium, gold, or conductive polymers, such as graphene) at least partially lining a peripheral wall delimiting the cavity in the stack. In particular, the conductive shielding or coating may partially or preferably entirely cover the cavity peripheral wall apart from the opening (and optionally apart from a second opening). Such a conductive shielding or coating may, for instance, be deposited on a peripheral wall of the cavity, for instance by plating, sputtering, etc.

In the context of the present application, the term "opening of conductive shielding on top extremity of cavity" may particularly denote a hole (in particular a through hole) in the conductive shielding at a top side of the cavity. Said hole may extend through the total thickness of the electrically conductive material of the conductive shielding in stack thickness direction. In an example, the opening of the conductive shielding on top extremity of cavity may have a round and/or edged (for example polygonal) shape (in a cross sectional view of the component carrier).

In the context of the present application, the term "antenna" may particularly denote a patterned electrically conductive structure shaped, dimensioned and configured to be capable of receiving and/or transmitting electromagnetic radiation signals, in particular radiofrequency (RF) signals, for instance of a specific frequency or frequency range. By such an antenna structure formed in and/or on the stack (in particular formed as an integral part of the stack), a signal may be coupled into the cavity-based waveguide or out of the cavity-based waveguide.

In the context of the present application, the term "opening of conductive shielding vertically associated with an antenna provided on top of and/or at said opening" may particularly denote a spatial and functional correlation between the top-sided opening of the conductive shielding and the antenna at and/or above a top side thereof. Said correlation may be so that electromagnetic radiation may be coupled from the waveguide-type cavity through the opening towards the antenna for emission towards an environment, and/or so that electromagnetic radiation captured by the antenna may be forwarded from the antenna through the opening towards the waveguide-type cavity for processing by electrically conductive layer structures of the component carrier. In an example, at least part of the area of the opening of the conductive shielding overlaps with the projected area of the antenna perpendicular to the stack thickness direction (i.e. referenced to stack thickness direction).

In the context of the present application, the term "method of dimensioning a component carrier" may particularly denote a process of determining a design rule for manufacturing a component carrier in which geometrical parameters of a cavity of the component carrier are determined for complying with one or more predefined criteria related to electromagnetic wave transmission by said cavity. However, the method of dimensioning a component carrier may also encompass manufacture of a correspondingly dimensioned component carrier. Said geometrical parameters may comprise at least a horizontal width and a vertical height of the cavity, wherein a vertical direction may correspond to a stacking direction of the layer structures of the stack and a horizontal direction may be perpendicular to said vertical direction.

In the context of the present application, the term "bandwidth of electromagnetic wave transmission" may particularly denote a frequency range over which the electromagnetic wave transmission is accomplished by a component carrier with antenna and waveguide-type cavity. To put it shortly, the larger the frequency range of transmitted waves and thus the bandwidth, the more data can be transmitted over the communication channel.

In the context of the present application, the term "return loss of electromagnetic wave transmission" may particularly denote a measure in relative terms of a power of a signal reflected in a transmission line, for example by a discontinuity in a transmission line. For instance, such a discontinuity can be caused by a mismatch between a termination or load connected to the transmission line and a characteristic impedance of the transmission line. Thus, when a signal is transmitted through a transmission line, some signal power is reflected or returned to the source due to one or more discontinuities in the transmission line. For example, such a discontinuity can be the connection to a system, another transmission line and/or a connector. The measure of this reflected power can be denoted as return loss.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment, a (for example laminated) layer stack-type component carrier (such as a PCB or an IC substrate) may be provided with a cavity formed inside of the stack. Peripheral walls of said cavity may be partially covered by an electrically conductive shielding (for example a metal lining) so that a low loss hollow waveguide may be formed by the cavity and its conductive shielding. Descriptively speaking, a cavity delimited by conductive shielding in a layer stack of a component carrier may function as a Faraday cage, promoting radiofrequency signal transmission with low loss and high signal integrity. Said conductive shielding may be opened selectively at a top side of the cavity for electromagnetically coupling an interior of the cavity with a top-sided antenna. Thus, the top-sided opening may face a patterned structure forming said antenna for establishing a vertical association between opening and antenna. Advantageously, the antenna may be integrally formed with the stack. Consequently, a simple manufacturing process may be combined with a highly efficient electromagnetic coupling and with a compact design integrating both waveguide as well as antenna in the stack. Moreover, such a design may lead to a high-bandwidth, good directivity and/or high radiation efficiency. Exemplary embodiments may provide an all-in-one solution with waveguide cavity and antenna integrated in the same stack without a need to assemble different parts, thereby avoiding alignment issues. By a direct feed architecture, losses may be reduced or even eliminated. A high reliability may be combined with a small form factor.

In particular, the described waveguide-antenna configuration of a component carrier according to an exemplary embodiment may be fully compatible with very high frequencies even above 50 GHz. In a preferred specific embodiment, an air-filled waveguide-type cavity may be provided in combination with a slot antenna, both being integrated in a laminated layer stack. This may lead to a component carrier with excellent high frequency behavior.

Preferably, a component carrier of the above configuration may be manufactured in accordance with a highly advantageous dimensioning rule. It may be advantageously possible to decrease a value of the ratio between the height and the width of the cavity for enhancing bandwidth. Additionally or alternatively, it may be possible to increase the value of the ratio between the height and the width of the cavity to decrease the return loss. Hence, a height to width ratio may be selected to focus on bandwidth or return loss, or to achieve a proper tradeoff between both. In terms of the cavity dimensioning, one or more criteria can be taken into account, which may be related to a target bandwidth characteristic and/or a target return loss characteristic.

In the following, further exemplary embodiments of the component carrier and the method will be explained.

In an embodiment, the antenna may be formed as a patterned metallic structure. In another embodiment, the antenna may be formed as a dielectric resonance antenna structure.

In an embodiment, the stack comprises an electrically insulating layer closure structure provided on the top extremity of the cavity. Preferably, the electrically insulating layer closure structure may be provided directly on the top extremity of the cavity. Preferably, the electrically insulating layer closure structure is provided in contact with an external electrically conductive layer structure defining part of the conductive shielding surrounding the cavity. The electrically insulating layer closure structure may be a continuous or patterned dielectric layer.

In particular, at least one of the electrically insulating layer structures (and in particular the electrically insulating layer closure structure) may comprise a Low-Dk material. More specifically, Low-Dk materials may be implemented along a radiofrequency signal path (for instance from a radiofrequency integrated circuit through a stripline including a transition structure and the waveguide-type cavity through the antenna). In particular, the Dk value of a respective one of the electrically insulating layer structures may be in a range from 1 to 10, preferably in a range from 1.1 to 4.

In an embodiment, said electrically insulating layer closure structure covers the opening of the conductive shielding. In other words, said electrically insulating layer closure structure may close the opening. This may hermetically seal an interior of cavity, and in particular its conductive shielding, with regard to an environment. This may prevent an interior of the component carrier from undesired influences, such as corrosion and/or the entry of dirt.

In another embodiment, said electrically insulating layer closure structure has an aperture connected to the opening of the conductive shielding. Thus, it may be possible to have a further aperture disconnected from the first one. Preferably, the aperture overlaps the shielding opening, more preferably it completely overlaps or is in flush with the opening. In such an embodiment, a pressure communication between the cavity and an exterior of the component carrier may be enabled through opening and aperture, so that pressure differences can be balanced out without harming the component carrier. If an extra protection against corrosion and the entry of dirt into the cavity shall be provided, it may be possible to close opening and aperture by a flexible or elastic membrane.

In an embodiment, said aperture is opened to the external side of the stack. In particular, said aperture may be configured to contribute to a slot antenna configuration of said antenna. More specifically, the opening may be formed as an oblong slot in an electrically conductive layer structure to thereby form a slot antenna. In this context, said aperture may additionally contribute to the slot antenna function.

In an embodiment, a further aperture is provided on top of the aperture, said aperture and said further aperture being configured to enlarge an opening area towards an external side of the stack. In particular, aperture and further aperture may contribute to a horn antenna configuration of said antenna. For instance, the further aperture may have a larger opening diameter than the aperture, and the aperture may have a larger opening diameter than the opening to thereby form a horn-shaped stepped structure. Aperture and further aperture may form a stepped configuration being wider at an exterior interface of the component carrier as compared to an interior interface to the cavity. Alternatively, a tapering aperture may be provided which enlarges towards an external side of the stack for forming a conical or frustoconical horn antenna. Thus, a tapering aperture may be provided as a frustoconical opening. Such a tapering aperture arrangement may be wider at an exterior interface of the component carrier as compared to an interior interface to the cavity. This may bring the advantage of the provision of an antenna delivering adequate directivity of radio frequency in an easy way by applying component carrier related manufacturing processes.

In an embodiment, the stack comprises at least one further electrically insulating layer structure provided on top of the electrically insulating layer closure structure. By such one or more additional electrically insulating layer structures, the characteristics of the antenna can be further refined, modified or changed. Furthermore, the shape of an exterior aperture can be refined by patterning such at least one additional electrically insulating layer structure.

In an embodiment, the further aperture is at least partially provided in said at least one further electrically insulating layer structure. The aperture and the further aperture may be formed to flush with each other, thereby having an impact on the antenna functionality.

In an embodiment, the at least one further electrically insulating layer structure closes the aperture and/or the further aperture. This may protect the cavity against exterior influence, such as moisture or dust.

In an embodiment, the stack comprises, on top of a stack portion defining the cavity, an electrically conductive layer structure. In particular, said electrically conductive layer structure may be provided between said stack portion and the electrically insulating layer closure structure. Preferably, this electrically conductive layer structure defines the top extremity of the conductive shielding and/or the opening of the conductive shielding. This may bring the advantage of further reduced losses of (in particular radio-) frequency propagation inside the cavity.

In an embodiment, the stack comprises a further electrically conductive layer structure between the insulating layer closure structure and the at least one further electrically insulating layer structure. This may have advantages in terms of a fine-tuning of directivity, bandwidth and radiation efficiency in case of use of a slot antenna.

In an embodiment, one of the plurality of electrically conductive layer structures, which is provided above the opening of the conductive shielding, has a functional opening. This functional opening may contribute to the formation of a slot antenna configuration of said antenna.

More generally, the antenna may be configured as a slot antenna. A slot antenna may be formed as a structured metal surface, preferably a metal foil or a deposited metal layer of the stack, with one or more slot-shaped openings formed therein, wherein the structured metal may delimit the boundaries of a slot antenna. When this structured metal layer is driven as an antenna by an applied radio frequency signal, the slot radiates electromagnetic waves in a way similar to a dipole antenna. The shape and size of the one or more slots, as well as the driving frequency, determine the radiation pattern. Integrating a slot antenna into a laminated layer stack is a perfect match, since the planar characteristic of the slot antenna and the planar characteristic of the stack correspond to each other.

In an embodiment, one of the plurality of electrically conductive layer structures, which is provided above the opening of the conductive shielding, and a neighbouring of the electrically conductive layer structures are connected with each other by at least one vertical through connection. In particular, they can be connected by a plurality of vertical through connections placed around a functional opening contributing to the formation of a slot antenna configuration of said antenna. Thus, an electrically conductive layer structure forming a top portion of the conductive shielding may be connected with a further electrically conductive layer structure on top of it. Said conductive layer structures may be mutually spaced by the electrically insulating layer closure structure, and the mentioned electrical connection may be accomplished by one or more vertical through connections, such as copper filled (for example laser) vias. The connection of said two electrically conductive layer structures by vertical through connections may prevent floating electric potentials. This may have an additional positive impact on signal loss and signal integrity. Said two electrically conductive layer structures may be vertically spaced by an electrically insulating layer structure, and may be interconnected by the vertical through connection(s).

In an embodiment, peripheral walls of the aperture and/or of the further aperture are shielded by a conductive material (such as copper). In particular the aperture and the further aperture may be in flush with each other and may form a stepped configuration. The coating of the sidewalls of the apertures by the conductive material may lead to a horn antenna.

More generally, the antenna may be configured as a horn antenna. A horn antenna may denote an antenna configuration formed of a flaring metal structure shaped like a horn with stepped or tapering geometry to direct radio waves in a beam. Advantages of a horn antenna are moderate directivity, broad bandwidth, low losses, and simple construction and adjustment. A laminated layer stack, with the options of patterning and depositing metal on sidewalls as available in printed circuit board technology, offers an excellent basis for forming a horn antenna integrated in such a laminated layer stack.

In an embodiment, the component carrier comprises a radiofrequency filtering structure configured as a top portion of the stack. By such a frequency filter, a target frequency or target frequency range may be precisely adjusted, which may lead to a highly accurate signal transmission.

In an embodiment, the component carrier comprises a radiofrequency lens component being surface mounted on top of the stack. Rather than being integrated in the stack, the mentioned radio frequency lens component may be an SMD (surface mounted device) component. By taking this measure, emitted and/or received radio frequency waves may be focused. This may lead to an improved signal transmission. As an alternative to a surface mounted radio frequency lens component, another embodiment may also integrate a radiofrequency lens in the stack.

In an embodiment, the opening is a slot and the functional opening is a further slot. Optionally the slot and the further slot are inclined relatively to each other in a top view on the stack. By configuring the top-sided opening in the conductive shielding and the functional opening on top thereof as slots (i.e. as oblong holes, for example having a length to width ratio of at least 1.5, preferably of at least 3), shape and dimension of the slots can be designed for adjusting desired radiofrequency characteristics. A mutual inclination angle between opening and functional opening may be a powerful design parameter for fine-tuning the radiofrequency properties.

In an embodiment, the conductive shielding has a plurality of openings on the top extremity of said cavity along the stack direction, said openings being vertically associated with the antenna provided on top of and/or at said openings. Optionally, the openings are inclined relatively to each other in a top view on the stack. In particular number, shape, and mutual orientation of the plurality of openings in the top side of the conductive shielding may be adjusted for setting target properties of the waveguide and/or the antenna.

In an embodiment, the conductive shielding comprises a further opening on a bottom extremity of said cavity along the stack direction. Such a further opening may form or form part of a feedline structure for feeding an electromagnetic signal into the cavity for subsequent emission of radiofrequency waves by the antenna. Preferably, the further opening is opposed to the opening of the top extremity. The openings may functionally cooperate and/or may be geometrically aligned with each other. More generally, the openings may be aligned, misaligned, offset, and/or rotated with respect to each other.

In an embodiment, the opening is a slot and the further opening is another slot. Optionally, the slot and the other slot are inclined relatively to each other in a top view on the stack. By configuring the top-sided opening and the bottom-sided opening in the conductive shielding as slots (i.e. as oblong holes, for example having a length to width ratio of at least 1.5, preferably of at least 3), shape and dimension of the slots can be designed for adjusting desired radiofrequency characteristics. A mutual inclination angle between opening and further opening may be a powerful design parameter for fine-tuning the radiofrequency properties.

In an embodiment, a surface center of the cavity and a surface center of the opening are aligned in accordance with a planar tolerance range of less than 100 µm, preferably less than 50 µm. The alignment may be with respect to a respective barycenter. Radiofrequency coupling into and out of the cavity may be rendered precise by aligned openings on the bottom side on the top side of the conductive shielding.

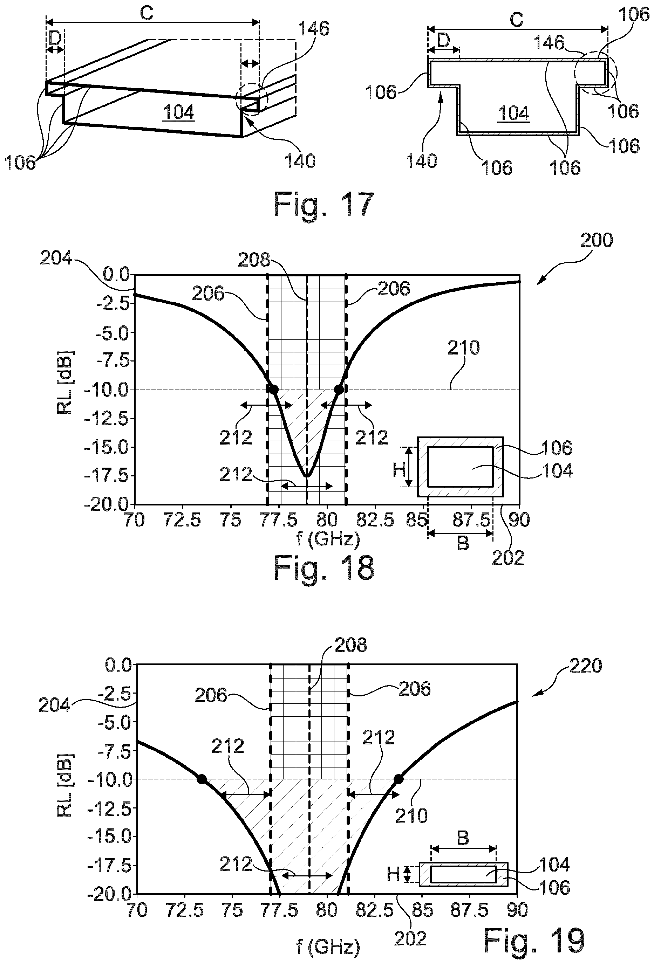

In an embodiment, the cavity has a stepped edge enlarging an extension of said cavity (see Figure 17). This may have a positive impact on the waveguide function of the cavity. The stepped shape may be at at least one of the top extremity and a bottom extremity of the cavity. Preferably, the cross section extension occurs along a linear and planar extension of the cavity. In particular, the stepped edge may be provided at the top extremity of the cavity.

In an embodiment, the stepped edge is covered by an electrically conductive structure, in particular is at least partially covered by the conductive shielding. By the electrically conductive structure, continuous metal coverage at the stepped edge may be ensured. This may have a positive impact on the radiofrequency losses.

In an embodiment, a width from an end of the stepped edge to an opposing end of the cavity minus an average width of the cavity (which may be the arithmetic average of the horizontal cavity extensions averaged over the entire vertical extension of the cavity) divided by the average width of the cavity is in a range from 0.001% to 20%, in particular in a range from 0.1% to 10%. For instance, a lateral extension of the cavity (i.e. an extension at one cavity corner beyond a rectangular cavity section) at the stepped edge has a maximum distance of not more than 250 µm, in particular of not more than 100 µm. Even if the stepped region is relatively small compared to the overall cavity dimensions, its impact on the radiofrequency loss characteristics of the waveguide-antenna structure may be significant.

In an embodiment, the component carrier comprises a conductive connection medium around a circumference of the cavity, in particular around a circumference enclosing the top extremity of said cavity. For instance, said conductive connection medium may be made of a solder structure or a sinter structure. The conductive connection medium may be provided on the top and/or on the bottom of the cavity, in particular in one or more corner regions thereof. Descriptively speaking, the conductive connection medium may cover weak points concerning metal coverage of the cavity surrounding. Such weak points may be in particular present in corners of the cavity, where the conductive shielding may be unintentionally not entirely closed, or where a stepped edge may be present. The more reliable the electrically conductive structure is closed in corners, the better the radiofrequency transmission. Thus, the additional electrically conductive structure may reduce radiofrequency losses.

In an embodiment, the conductive connection medium is electrically connected along the stack direction to two electrically conductive layer structures, in particular including an upper electrically conductive layer structure being at a vertical level of the upper extremity of the cavity. In one embodiment, said coupling may be direct. In another embodiment, said coupling may be indirect via a portion of the conductive shielding. By the mentioned electric coupling, floating potentials inside the component carrier may be prevented.

In an embodiment, the lateral extension of the stepped edge is at least partially delimited by the conductive connection medium. In particular, the conductive connection medium may cover or define at least part of an edge and/or at least part of the corner of the conductive shielding.

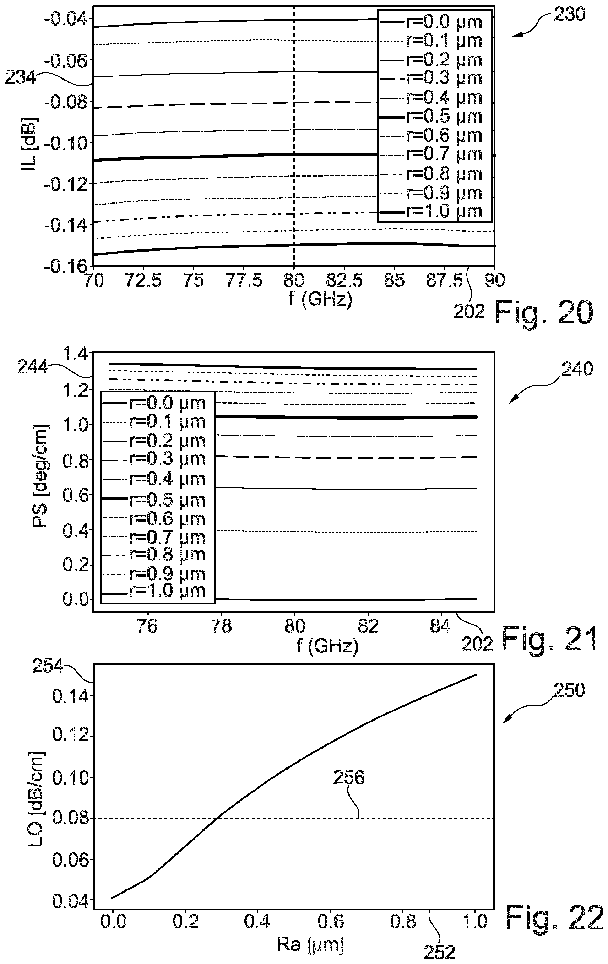

In an embodiment, a roughness Ra of the conductive shielding covering the top extremity and/or a bottom extremity of the cavity has a value lower than that of lateral walls of the conductive shielding covering the peripheral wall of the cavity. In particular, the roughness Ra of the conductive shielding covering the top extremity and/or the bottom extremity of the cavity may have a value between 0.01 µm and 1 µm, preferably between 0.1 µm and 0.4 µm. In particular, the roughness of the conductive shielding surrounding the cavity may have a significant impact on signal loss (in particular insertion loss) and/or phase shift of the waveguide-antenna arrangement (see Figure 20 to Figure 22). Thus, a sufficiently smooth interior surface of the conductive shielding may have a positive impact on the waveguide-antenna performance. Without wishing to be bound to a specific theory, it is presently believed that unintentional damping effects on radiofrequency signal transmission resulting from the skin effect may be significantly suppressed when a small surface roughness is achieved.

In an embodiment, a horizontal width of the cavity is greater than a vertical height of the cavity. Said vertical extension may be measured along the stack direction, whereas said horizontal extension may be calculated perpendicular to the stack direction. In the cross section of the cavity (in x/y and z direction) extending along a developing direction, said direction can have for example a straight, fragmental, curved and/or fuzzy development.

In an embodiment, said width is at least twice of said height. Said width may be at least three times of said height. Moreover, said width may be less than ten times of said height, preferably less than seven times of said height. Adjusting the width to height ratio may have an impact on important waveguide-antenna characteristics, such as return loss and bandwidth.

In an embodiment, the cavity is configured for a frequency of at least 75 GHz. For example, the cavity has a width of less than 3 mm and a height of less than 1.5 mm. In other embodiment, the cavity may be adjusted for other frequencies, for instance a frequency of at least 10 GHz or a frequency of at least 50 GHz.

In an embodiment, the cavity is filled with a medium. Preferably, said medium may be air, so that the cavity may be an air-filled waveguide. As an alternative to air, the cavity may be filled with a sponge, and/or a dielectric material.

In an embodiment, the electrically conductive layer structures at the bottom of the cavity comprises a feedline structure for coupling a signal between into and/or out of the waveguide. Thereby, an electric transition between waveguide and stack metal may be accomplished.

In an embodiment, the component carrier is used for high-frequency applications above 1 GHz, in particular about 50 GHz. In particular for such high frequencies, signal transmission is particularly sensitive to surface roughness caused artefacts in view of the skin effect. The high performance of component carriers according to exemplary embodiments of the invention allows low loss signal transmission even with such high-frequency values.

In an embodiment, the electrically insulating layer closure structure (of the component carrier) comprises a material different from the materials of the other electrically insulating layer structures. Preferably, the electrically insulating layer closure structure may comprise or consist of a material having a dielectric constant (Dk) smaller than 3.7, in particular in the range between 1.5 to 3.5, whereas material of the other electrically insulating layer structures may have a dielectric constant larger than 3.8, in particular in the range from 3.8 to 4.5. This may bring the advantage that losses of the transmission of an electromagnetic wave between the (top extremity of the) cavity and the antenna are reduced since a material having preferred physical properties is located between the cavity and the antenna.

According to a further embodiment, one or a plurality of through holes are provided in said electrically insulating layer closure structure, in particular connected to the opening of the conductive shielding. Additionally or alternatively, the one or the plurality of through holes may be connected to one of the plurality of electrically conductive layer structures. Preferably, the one or at least one of said plurality of through holes may be filled with gas, or example air. This may bring the advantage that electrically insulating layer closure structure loses weight compared to an electrically insulating layer closure structure having no through holes. Additionally or alternatively this may bring the advantage that losses of the transmission of electromagnetic waves between the (top extremity of the) cavity and the antenna are reduced, since for example air has a dielectric value of 1.0.

According to a further embodiment, the one or the plurality of through holes comprises an extension, for example a diameter, perpendicular to stack direction smaller than 25 µm, in particular in the range between 500 nm to 15 µm. This may bring the advantage that the cavity is fuidically connected to the environment, however liquids, for example water (droplets) cannot pass the through holes due to physical forces, for example surface energy.

According to a further embodiment, the aperture comprises the one or plurality of through holes. This may directly fluidically connect the cavity with the environment and thus ensure the exchange of pressure between the cavity and the environment.

In an embodiment, the one or the plurality of through holes are configured to connect the functional opening with the opening vertically associated with the antenna. This may bring the advantage of enhance the transmission an electromagnetic signal via the cavity, the one or the plurality of through holes to the functional opening having low losses, since the electromagnetic wave propagation is guided through a path, wherein at least a part or a portion of the path comprising material having lower Dk values, preferably comprising air having a dielectric constant of 1.0, compared to the surrounding material of the path.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (for example based on polyphe-nylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectrome-chanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 illustrates a cross-sectional view of a component carrier according to another exemplary embodiment of the invention.
Figure 3 illustrates a top view of a component carrier according to an exemplary embodiment of the invention of the type of Figure 2.
Figure 4 illustrates a cross-sectional view of a component carrier according to another exemplary embodiment of the invention.
Figure 5 illustrates a cross-sectional view of a component carrier according to another exemplary embodiment of the invention.
Figure 6 illustrates a cross-sectional view of a component carrier according to another exemplary embodiment of the invention.
Figure 7 to Figure 9 illustrate cross-sectional views of structures obtained during carrying out a method of manufacturing a component carrier according to an exemplary embodiment of the invention.
Figure 10 illustrates a three-dimensional view of a component carrier according to an exemplary embodiment of the invention.
Figure 11 illustrates a cross-sectional view of a component carrier according to another exemplary embodiment of the invention.
Figure 12 illustrates a cross-sectional view of a component carrier according to another exemplary embodiment of the invention.
Figure 13 illustrates a cross-sectional image of a component carrier according to an exemplary embodiment of the invention.
Figure 14 illustrates a cross-sectional image of a component carrier according to an exemplary embodiment of the invention.
Figure 15 illustrates a cross-sectional image of a component carrier according to an exemplary embodiment of the invention.
Figure 16 illustrates a cross-sectional image of a component carrier according to an exemplary embodiment of the invention.
Figure 17 illustrates a three-dimensional view and a cross-sectional view of a conductive shielding around a cavity of a component carrier according to another exemplary embodiment of the invention.
Figure 18 shows a diagram indicating return loss over frequency of a component carrier according to an exemplary embodiment of the invention.
Figure 19 shows a diagram indicating return loss over frequency of a component carrier according to another exemplary embodiment of the invention.
Figure 20 shows a diagram indicating insertion loss over frequency of a component carrier according to an exemplary embodiment of the invention.
Figure 21 shows a diagram indicating phase shift over frequency of a component carrier according to an exemplary embodiment of the invention.
Figure 22 shows a diagram indicating loss over roughness of a component carrier according to an exemplary embodiment of the invention.
Figure 23 illustrates a cross-sectional view of a component carrier according to another exemplary embodiment of the invention.
Figure 24 illustrates a top view of the component carrier according to Figure 23.
Figure 25 illustrates a cross-sectional view of a component carrier according to another exemplary embodiment of the invention.
Figure 26 illustrates a cross-sectional view of a component carrier according to another exemplary embodiment of the invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

Moving towards higher frequencies requires solutions for an improved loss performance and smaller structures preferably on PCB level. However, conventional approaches are mainly based on molded polymer-based antennas (for example gap waves) which are subsequently metalized. These antennas are assembled onto a PCB and require assembling technologies as well as interconnect-technologies accordingly.

According to an exemplary embodiment, a component carrier (for example a printed circuit board, PCB) can be formed on the basis of a laminated layer stack, i.e. a stack of layer structures connected by pressure and/or heat. A cavity may be formed as a hollow volume in the stack which is delimited by peripheral walls (which may include sidewalls as well as bottom and top walls). Said peripheral walls may be lined partially by an electrically conductive shielding for enhancing electromagnetic wave transmission. Preferably, the electrical conductivity of the electrically conductive shielding is higher than 10⁷ S/m (at 20° C). A top-sided opening of the shielding may promote an electromagnetic coupling between the waveguide-cavity and a top-sided antenna. As a result, opening and antenna may be vertically associated with each other for accomplishing an excellent electromagnetic coupling in between. Such a component carrier may be manufactured with low effort and small space consumption, and may show advantageous properties in terms of electromagnetic coupling. Further advantages, such as a high-bandwidth, a well-defined directivity and/or a high radiation efficiency may be achieved as well. Thus, a component carrier with excellent high-frequency properties may be obtained. To put it shortly, an exemplary embodiment of the invention provides a waveguide antenna on PCB level, i.e. formed as an integral part of a stack of layer structures, and couples it above a waveguide cavity.

In an advantageous configuration, a ratio between the height and the width of the cavity may be adjusted for tuning the bandwidth and/or return loss properties of the waveguide-type cavity. It has been found that a smaller height-to-width ratio of the cavity promotes high bandwidth, whereas a larger height-to-width ratio of the cavity may lead to low return loss. By adjusting the dimensions of the cavity, the component carrier may be tuned in terms of its height-to-width ratio of the cavity, which may impact bandwidth and/or return loss properties.

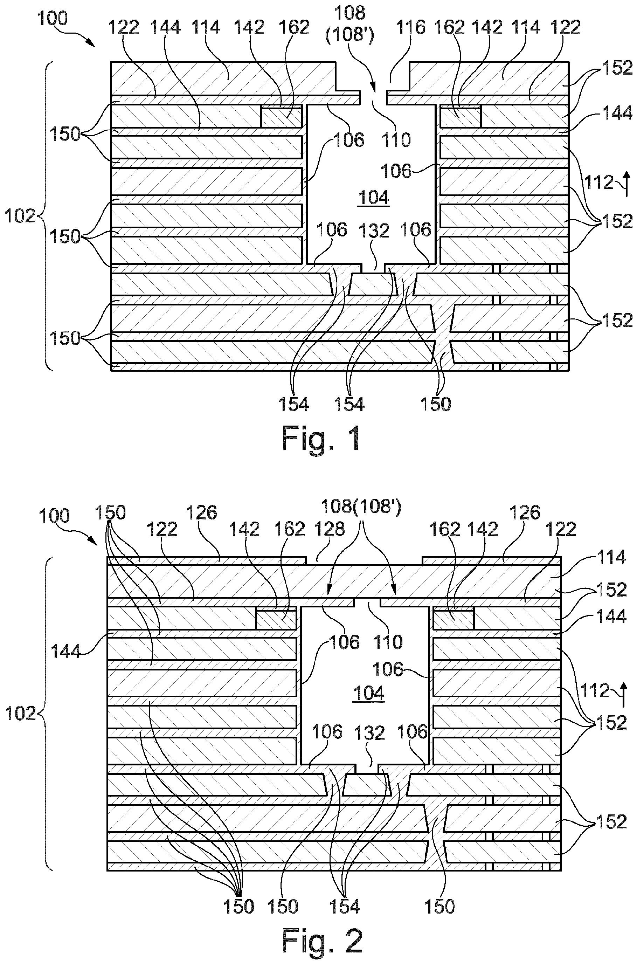

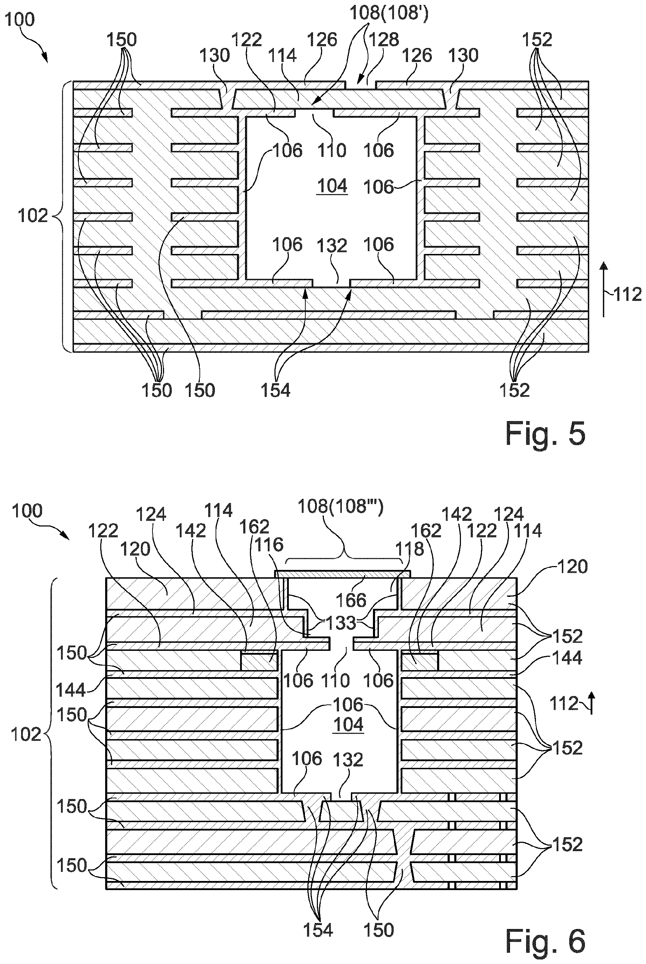

In particular, an exemplary embodiment of the invention provides a slotted waveguide antenna combined with air filled substrate integrated waveguide (see in particular Figure 1 and Figure 2). However, other embodiments provide a horn antenna (see for instance Figure 6). Combinations are possible.

More specifically, an exemplary embodiment of the invention provides a waveguide-based antenna on PCB level as an all-in-one solution. In particular, both cavity as well as antenna may form an integral part of a laminated layer stack of the component carrier according to an exemplary embodiment of the invention. No SMD-assembly of a separate antenna is needed according to an exemplary embodiment of the invention, as the antenna of a component carrier of an embodiment may be directly manufactured on PCB level, i.e. in-situ the stack. For instance, the antenna of a component carrier of an exemplary embodiment of the invention may be produced by using slots or openings obtained in a hollow structure that is connected to a waveguide. Such a waveguide-fed slot antenna may be preferred over conventional moulded waveguide antennas. According to an exemplary embodiment, this may offer the advantages of improved loss performance and improved mechanical reliability, in view on the absence of additional assembling technologies. Thus, exemplary embodiments of the invention may combine an antenna and a feeding structure by implementing hollow structures in combination with slots and transition structures in the layer stack of the component carrier. One or more slots, that may be used as antenna, can be obtained directly from the hollow structure (see Figure 1) or, recesses are applied onto an additional copper layer separated from the hollow structure by a dielectric material (see Figure 2). Preferably but not necessarily, the latter embodiment may have a low-Dk material sandwiched between the hollow structure and/or the additional electric layer.

Hence, exemplary embodiments of the invention may provide an all-in-one solution of a stack-integrated antenna and waveguide-type cavity allowing for the manufacture of waveguide antennas on component carrier (in particular PCB) level additionally yielding miniaturized antennas. In this context, it may be possible to implement a hollow structure inside the component carrier (for example PCB) having openings.

Exemplary embodiments may allow for a direct feeding out of an air-filled substrate integrated waveguide (AFSIW), so that no losses may occur due to no transition. Furthermore, component carriers according to exemplary embodiments may show a high mechanical reliability, a low loss performance, and/or a small form factor. Exemplary embodiments may furthermore be compatible and scalable with or for millimeter-wave devices. Apart from this, component carriers according to exemplary embodiments of the invention are compatible with embedded components, surface mounted devices and IC substrates. Due to the waveguide-cavity and stack-integrated antenna design of a component carrier of an exemplary embodiment of the invention, simple dielectric material may be sufficient. Sophisticated and expensive high-frequency-optimized materials (such as low-Dk materials, Rogers^{™} materials, for example RO3003, etc.) may be dispensable or may be reduced in comparison with conventional approaches.

Exemplary applications of exemplary embodiments of the invention are millimeter-wave devices , for example operating at or above 77 GHz, or even at or above 140 GHz. For instance, such component carriers may be configured for 5G or 6G applications, radar applications, etc. Other advantageous applications of exemplary embodiments may be component carriers with sensing functionality and/or motion detection functionality. When operating in the lower millimeter-wave spectrum, the waveguide-type cavity of the component carrier of an exemplary embodiment of the invention can be implemented in half-mode. A specific application of a component carrier according to an exemplary embodiment is a 77 GHz hollow waveguide-fed slot antenna for an automotive radar device.

Advantageously, a waveguide antenna of an exemplary embodiment may be integrated in a component carrier stack, for instance on PCB level. An exemplary embodiment may provide an all in one solution with radio frequency (RF)-board, feeding structure and antenna integrated in a common component carrier layer stack.

According to an exemplary embodiment of the invention, a stack-integrated slotted waveguide antenna may be combined with an air-filled substrate integrated waveguide. This may provide low radiofrequency losses. For instance, this may render the component carrier highly appropriate for radar applications or other applications operating in multiple frequency ranges.

In an embodiment, an air-filled substrate integrated waveguide, in form of the cavity with conductive shielding, may be combined with a slot antenna for obtaining improved signal integrity with low loss. More specifically, a PCB-integrated slot antenna may allow to reduce losses dramatically. The integrated waveguide-type metallized cavity may offer a very high power handling capability.

To transmit an electromagnetic signal with high performance, the component carrier may comprise an antenna formed as part of the stack, rather than being a surface mounted device. A particularly preferred option may be the combination of a slot antenna with a metallized cavity in form of an air-filled substrate integrated waveguide. This may allow to achieve excellent antenna performance in terms of bandwidth, gain, radiation efficiency and/or beam pattern. To form such an antenna in combination with an air-filled substrate integrated waveguide in form of the metallized cavity, no special high-frequency dielectric materials need to be implemented (but may be optionally implemented for further improving performance). This may be due to the fact that the only small amount of dielectric material which surrounds the antenna, may be negligible. The antenna (preferably a slot antenna) may be formed during PCB manufacture, for instance by an etching process or by laser processing. Alternatively, additive processes, for example plating and/or physical or chemical vapor deposition, may be used. This may lead to a simple manufacturing process.

Depending on a desired or required beam pattern, the antenna can be scaled easily by adjusting the number of radiation slots and/or the distance in between the slots. Such a scalable system may allow to freely adapt the antenna design to various applications, such as automotive radar, telecommunications, etc.

Due to the fact that transmitting and radiating parts may be produced together in one component carrier, a high mechanical stability can be achieved. When integrating both antenna and metallized cavity in the same stack, an all-in-one solution may be provided forming a radiofrequency front-end system.

**Figure 1** illustrates a cross-sectional view of a component carrier 100 according to an exemplary embodiment of the invention. In the shown embodiment, component carrier 100 is embodied as a printed circuit board (PCB). However, component carrier 100 may also be an integrated circuit (IC) substrate, etc.

Component carrier 100 according to Figure 1 comprises a laminated layer stack 102 comprising a plurality of electrically conductive layer structures 150 and of electrically insulating layer structures 152. The electrically conductive layer structures 150 may comprise patterned copper layers which may form horizontal antenna structures, horizontal shielding structures, horizontal pads and/or a horizontal wiring structures. Additionally, the electrically conductive layer structures 150 may comprise vertical through connections such as copper pillars and/or copper filled laser vias. Additionally or alternatively, mechanical plated through holes (PTH) may also be used as vertical through connections. Moreover, the stack 102 of the component carrier 100 may comprise one or more electrically insulating layer structures 152 (such as one or more prepreg sheets, resin sheets or cores made of FR4). Ajinomoto Build-Up Film ^{®} (ABF) materials are also possible for at least part of the electrically insulating layer structures 152, in particular when the component carrier 100 is embodied as an IC substrate. Also surface finish (like ENIG or ENEPIG, a solder resist, etc.) may be optionally applied on the top side and/or on the bottom side of the stack 102 (not shown).

For example, the electrically conductive layer structures 150, which may be embodied as copper layers, may have a thickness in a range from 5 µm to 200 µm, for example in a range from 20 µm to 30 µm. Some of the electrically insulating layer structures 152 may be prepreg layers with a thickness in a range from 20 µm to 300 µm, for example in a range from 60 µm to 100 µm. Other ones of the electrically insulating layer structures 152 may be core layers made of FR4 with a thickness in a range from 50 µm to 1000 µm, for example in a range from 150 µm to 400 µm.

Moreover, a cavity 104 is formed as an air-filled hollow volume in the stack 102. In the shown embodiment, the cavity 104 is filled with air. Hence, an air-filled waveguide structure integrated in stack 102 may be provided according to Figure 1. Alternatively, another medium may be filled into waveguide cavity 104, for instance, a dielectric solid or sponge medium. The cavity 104 may be delimited from the stack 102 by a peripheral wall, which may include a circumferentially closed sidewall as well as a bottom wall and a top wall. An electrically conductive shielding 106, for example a copper coating or a coating made of another metallic material, may cover a major portion of the peripheral wall of the cavity 104. More specifically, the electrically conductive shielding 106 may cover the entire peripheral wall with the exception of a bottom-sided opening 132 and a top-sided opening 110.

The cavity 104 with its metallic lining according to reference sign 106 may form an air-filled waveguide constituting a Faraday cage for electromagnetic radiofrequency waves. Advantageously, said waveguide-type cavity 104 being integrated in the stack 102 leads to a compact design and a high-power handling capability.

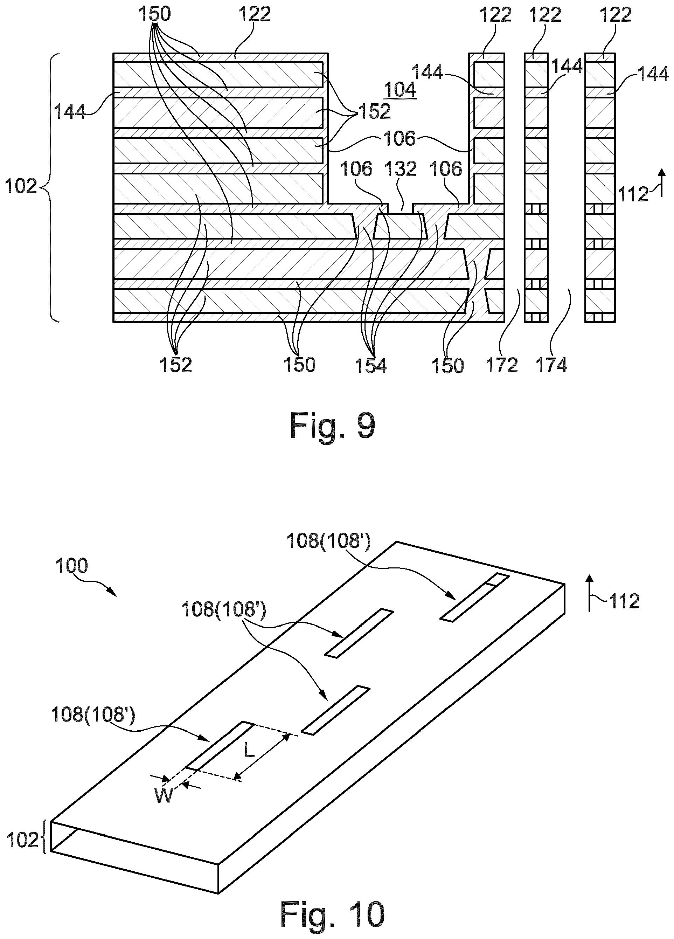

Furthermore, an antenna 108 (or antenna structure) is provided which is integrated in the stack 102. This further promotes the compact design of component carrier 100. In Figure 1, the antenna 108 may be defined by the uppermost electrically conductive layer structure 122 being a patterned copper layer having an oblong slot (see for example Figure 10), or a plurality of such oblong slots (see again Figure 10). Still referring to Figure 1, it can be seen that the conductive shielding 106 has an opening 110 on a top extremity of said cavity 104 along a stack direction 112. The top portion of the conductive shielding 106 may simultaneously form part of antenna 108. Said opening 110 is vertically associated with the antenna 108 provided at said opening 110. In the shown configuration, the antenna 108 may be embodied as a slot antenna 108'. More specifically, the opening 110 may define a lengthy slot with a length L being larger than its width W (see again Figure 10). For example, the length-to-width ratio W/L of the slot(s) may be at least two, for example at least four. For example, the length L of the antenna slot may be in a range from 1 mm to 5 mm, for instance 2 mm. For instance, the width W of the antenna slot may be in a range from 100 µm to 1 mm, for instance 200 µm to 700 µm. Formation of slot-shaped opening 110 may lead to a low loss of radiation. The described antenna design in combination with the waveguide design may lead to a resonator configuration for high-frequency electromagnetic radiation. The slot antenna 108' design of Figure 1 may allow to reduce losses significantly. To put it shortly, the slot antenna 108' of Figure 1 is embodied as an opened copper layer with one or more oblong slots.

During operation of component carrier 100 of Figure 1, a high-frequency signal (for instance having a frequency of 10 GHz or more, for instance 77 GHz) may be coupled into cavity 104 via a feeding structure 154 forming part of the electrically conductive layer structures 150 and being arranged below a bottom wall of the cavity 104. As shown as well in Figure 1, the conductive shielding 106 comprises a further opening 132 on a bottom extremity of said cavity 104 along the stack direction 112 and relating to said feeding structure 154. At the further opening 132, the above-described feeding structure 154 is formed for coupling an electromagnetic wave into the waveguide-type cavity 104. To put it shortly, the electromagnetic signal is fed into cavity 104 at the bottom of the waveguide via feeding structure 154. The high-frequency signal coupled into cavity 104 may for instance be generated by at least one electronic component (not shown), such as one or more semiconductor chips, which may be embedded in an interior of the stack 102 and/or surface mounted on top of the stack 102. Such a semiconductor chip may also be mounted on an IC substrate, which may form stack 102 or which may be provided in addition to stack 102. After being coupled from feeding structure 154 into cavity 104, the electromagnetic signal may be applied to antenna 108 for wireless transmission towards an environment of component carrier 100.

Alternatively, a high-frequency signal propagating in the environment of component carrier 100 may be captured by antenna 108, may be coupled into cavity 104 and may be further conveyed to electrically conductive layer structures at the bottom of the cavity 104 and from there towards an intended destination (such as an electronic component like a semiconductor chip) for further processing.

Thus, component carrier 100 can be configured as a radiofrequency transmitter, a radiofrequency receiver or a radio frequency transceiver (i.e. combined transmitter and receiver). It is also possible to provide a plurality of cavity-antenna-configurations in one and the same stack 102, for instance arranged side-by-side and laterally spaced by stack material.

Moreover, the stack 102 comprises an electrically insulating layer closure structure 114 (for instance made of core material such as FR4) provided on the top extremity of the cavity 104. Said electrically insulating layer closure structure 114 has an aperture 116 directly connected to the opening 110 of the conductive shielding 106. In Figure 1, aperture 116 has a larger diameter than opening 110. As shown, said aperture 116 is opened to the external side of the stack 102 and contributes to the formation of the slot antenna 108'.

As shown in Figure 1 as well, the aperture 116 may be formed only in one electrically insulating layer structure 152 of the stack 102 and may have both horizontal and vertical sidewalls defined by said electrically insulating layer structure 152. This may avoid any issues of oxidizing or corroding metallic surfaces what concerns the aperture 116 and its contribution to the handling of radiofrequency waves. Alternatively, also part of a neighbored electrically conductive layer structure 150 may delimit the aperture 116, which may have advantages in terms of radiation performance.

As shown, the stack 102 comprises, on top of a stack portion defining the cavity 104, electrically conductive layer structure 122 between said stack portion and the electrically insulating layer closure structure 114. The opening 110 is formed in said electrically conductive layer structure 122 for forming slot antenna 108'.

Preferably, a surface center of the cavity 104 and a surface center of the opening 110 are aligned in a horizontal direction in accordance with a planar tolerance range of less than 50 µm. This may lead to a high performance of the stack-integrated combined waveguide-antenna structure according to Figure 1.

Moreover, Figure 1 illustrates a conductive connection medium 142 around a circumference of the cavity 104. In Figure 1, the conductive connection medium 142 is arranged around a circumference enclosing the top extremity of said cavity 104. Preferably, said conductive connection medium 142 is made of a solder structure, for example comprising tin and/or antimony and/or bismuth and/or silver and/or zinc, or a sinter structure, for example copper and/or silver and/or gold and/or oxides of the listed metals or combinations thereof. The conductive connection medium 142 should have a high electrical conductivity, in particular higher than 10⁶ S/m (at 20° C), so as to contribute to the shielding function of electrically conductive shielding 106. Below the conductive connection medium 142 and laterally adjacent to the conductive shielding 106, a dielectric structure 162 is arranged. Dielectric structure 162 may be made of a build-up dielectric (for example plugin paste with low coefficient of thermal expansion (CTE), but more generally it can be any material suitable to gain height, for example locally applied prepreg; also copper can be used as build-up material). The conductive connection medium 142 is electrically connected, directly or indirectly via conductive shielding 106, to several electrically conductive layer structures stacked along the stack direction 112 (see in particular reference signs 122, 144), including upper electrically conductive layer structure 122 being at a vertical level of the upper extremity of the cavity 104.

Advantageously, a roughness Ra of the conductive shielding 106 covering horizontal top extremity and bottom extremity of the cavity 104 has a value lower than that of vertical lateral walls of the conductive shielding 106 covering the peripheral wall of the cavity 104. For instance, the roughness Ra of the conductive shielding 106 covering the top extremity and the bottom extremity of the cavity 104 has a value in a range from 0.05 µm to 0.5 µm. With such a low roughness, a low loss of a radiofrequency signal may be obtained. According to the skin effect, a high-frequency signal propagates only in a thin surface skin of an electrically conductive structure. When the surface is very smooth, signal losses may be significantly reduced.

Benefits of the component carrier 100 of Figure 1 with its stack-integrated slot antenna 108' and its stack-integrated waveguide-cavity 104 are ease of fabrication, no need for a special material of the lid, manufacturability with low effort, and no issues with air expansion. Additionally, portions of the electrically conductive layer structures 150 and/or the electrically conductive shielding 106, which may be in particular in direct contact with the environment, for example air or water, may be covered with a protection structure, which may reduce or even prevent decomposition, for example oxidation. The protection structure may be a (for instance continuous) layer of a metal, for example silver or gold, and/or an electrically insulating material, for example glass or ceramic.

**Figure 2** illustrates a cross-sectional view of a component carrier 100 according to another exemplary embodiment of the invention.

The embodiment of Figure 2 differs from the embodiment of Figure 1 in particular in that, according to Figure 2, said electrically insulating layer closure structure 114 covers and thereby closes the opening 110 of the conductive shielding 106. Preferably, the electrically insulating layer closure structure 114 may be free of reinforcing material, for example glass fibers or glass spheres (since this may lead to losses between the waveguide and the antenna). Alternatively, reinforcing material may be included in the electrically insulating layer structure, if a high mechanical strength is desired. For example, electrically insulating layer closure structure 114 of Figure 2 is a continuous closed layer, rather than a patterned layer as in Figure 1. However, when air expansion (for example during reflow) is an issue, an additional venting opening may be formed in a specific area which may then be covered with a membrane or the like, so that no corrosion can appear. Consequently, electrically insulating layer closure structure 114 full closes the cavity 104, which is thereby protected against environmental influences, such as corrosion. Complete closure of cavity 104 by continuous electrically insulating layer closure structure 114 may thus lead to a further improved signal loss protection.

Correspondingly, the uppermost one of the plurality of electrically conductive layer structures 126 which is provided above the opening 110 of the conductive shielding 106, has a functional opening 128. This may contribute to the formation of a slot antenna 108' configuration of said antenna 108. However, it is mainly electrically conductive layer structure 122 with slot-shaped opening 110 which predominantly defines the properties of the slot antenna 108'.

As shown, Figure 2 provides a slot antenna 108' with full material coverage. In the shown embodiment, functional opening 128 has a larger extension than opening 110. In addition to its low loss performance, the embodiment of Figure 2 has the further benefit of a very simple manufacturability.

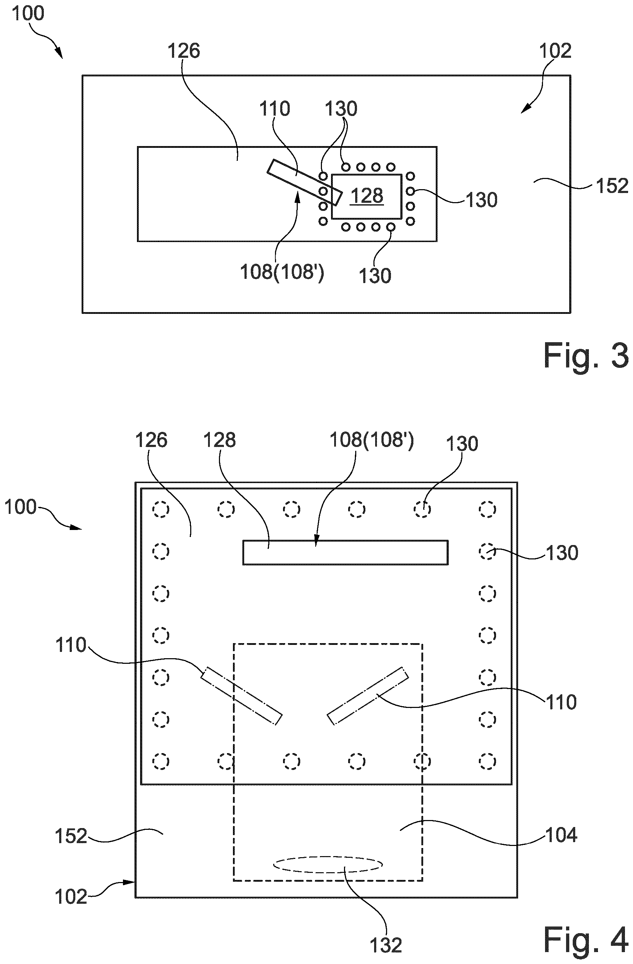

**Figure 3** illustrates a top view of a component carrier 100 according to an exemplary embodiment of the invention of the type of Figure 2. According to Figure 3, the opening 110 is a slot and the functional opening 128 is a further slot. As shown, the slot and the further slot are inclined relatively to each other and (at least partially) overlap with each other in the illustrated top view on the stack 102. A plurality of vertical through connections 130, which are here embodied as copper filled laser vias are placed around the functional opening 128 in the uppermost electrically conductive layer structure 126. This may contribute to the formation of a slot antenna 108' configuration of said antenna 108. Preferably, the area of the opening 110 (in the illustrated top view on the stack 102) may be free vertical through connections 130 (not shown). Optionally, vias (or other vertical through connections 130) may be arranged to provide a filter function, for instance for frequency filtering radiofrequency waves.

**Figure 4** illustrates a cross-sectional view in top view of a component carrier 100 according to another exemplary embodiment of the invention. **Figure 5** illustrates a cross-sectional view of a component carrier 100 according to still another exemplary embodiment of the invention.

In the embodiment of Figure 4, the conductive shielding 106 has a plurality of openings 110 on the top extremity of said cavity 104 along the stack direction 112, said openings 110 being vertically associated with the antenna 108 provided on top of and/or at said openings 110. Different ones of the openings 110 are inclined with respect to each other. Furthermore, each of the openings 110 is a slot, and the further opening 132 is another slot. As shown, the slots and the other slot are inclined relatively to each other in the shown top view on the stack 102. In the shown embodiment, the bottom slot (i.e. the further opening 132) and the top slots (i.e. the plurality of openings 110) do not have to have the same width and/or the same length and may be inclined. Also the bottom slot may also embodied as a plurality of slots, this may influence the filtering properties. A closest distance from an edge of the waveguide 104 to the opening 110 may be in a range from 100 µm to 400 µm.

Moreover, the elongation direction of the opening 110 may be not parallel to, but tilted with respect to the elongation direction of the functional opening 128 and/or of the antenna structure 108 (see Figure 3 and Figure 4). Alternatively, the elongation direction of the opening 110 may be parallel to the elongation direction of the functional opening 128 and/or the antenna structure 108. The opening 110 and the functional opening 128 may be transversely shifted in stack direction 112 so that in a top view, they do not overlap. The length and/or the width and/or the area of the cavity 104 perpendicular to the stack direction 112 is smaller than the length and/or the width and/or the area of the uppermost electrically conductive layer structure 126. Alternatively, the length and/or the width and/or the area of the cavity 104 perpendicular to the stack direction 112 may be the same or larger than the length and/or the width and/or the area of the uppermost electrically conductive layer structure 126. Preferably, a plurality of vertical through connections 130 may be placed at least partially around the functional opening 128 and/or the opening 110 in the uppermost electrically conductive layer structure 126.

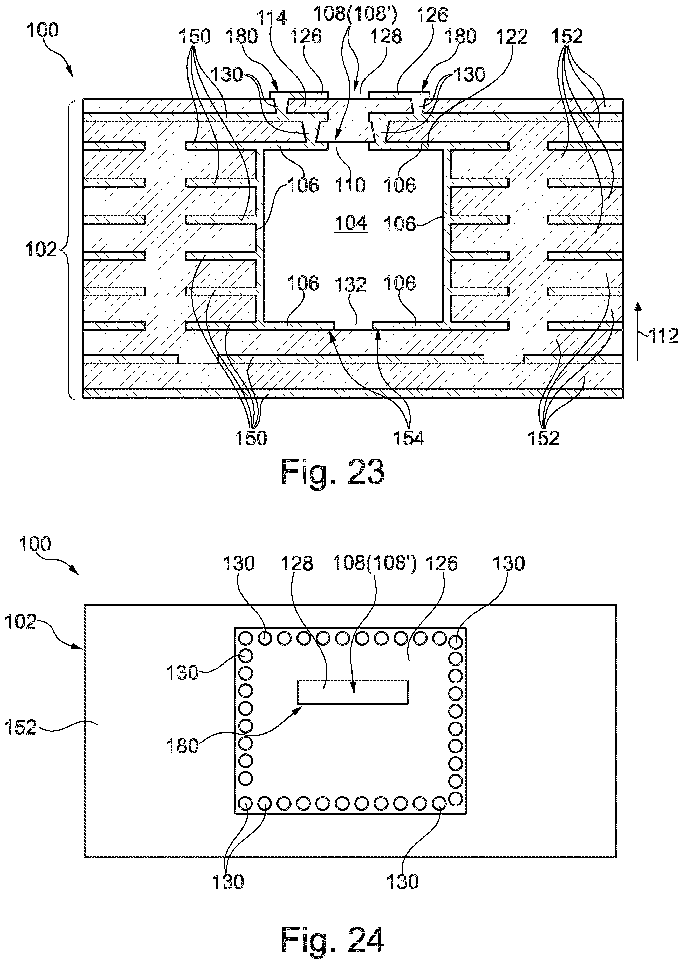

Figures 4, 5 (and Figures 23, 24) show a (waveguide-type) cavity 104 having a conductive shielding 106, in the top layer of the conductive shielding 106 there is an opening 110 with a function of a coupling slot which feeds a volume portion located between the electrically conductive layer structure 122 and the uppermost electrically conductive layer structure 126 (optionally laterally delimited by vertical through connections 130) acting as a filter. The functional opening 128 (top slot) acts as antenna (descriptively speaking as radiating slot). The slots do not need to be aligned on top of each other, they can be shifted for tuning the performance. Generally, opening 110 may be configured to act as a coupler and/or a filter.

**Figure 6** illustrates a cross-sectional view of a component carrier 100 according to another exemplary embodiment of the invention.

The embodiment of Figure 6 differs from the embodiment of Figure 1 in particular in that, according to Figure 6, a further aperture 118 is provided on top of and connected with the aperture 116. In Figure 6, said aperture 116 and said further aperture 118 are configured to form a stepped structure to enlarge an opening area towards an external side of the stack 102. This may form a horn antenna 108‴ configuration of said antenna 108. The further aperture 118 is provided in an uppermost further electrically insulating layer structure 120. Moreover, peripheral walls of the aperture 116 and of the further aperture 118 are shielded by a conductive material 133 which forms a continuous stepped metallic structure. Preferably, said conductive material 133 (which may be the same or a different material as the one used for conductive shielding 106) may cover the entire surface delimiting apertures 116, 118 in electrically conductive closure structure 114 and the upper electrically insulating layer structure 120.

The described stepped configuration of the apertures 116, 118 and the conductive material 133 thereon may configure the antenna 108 of Figure 6 as horn antenna 108"'. Such a horn antenna 108‴ may function as a traveling wave antenna (rather than a resonator antenna). The embodiment of Figure 6 may have a very large bandwidth. Thus, a specific advantage of the embodiment of Figure 6 is in particular a very high bandwidth being supported by the shown horn antenna 108‴ design.

In order to obtain a low loss configuration, the exposed surface of conductive material 133 should be very smooth, for instance should have a roughness Ra below 1 µm, preferably in a range from 0.1 µm to 0.4 µm.

Figure 6 illustrates a further advantageous option: As illustrated, a membrane 166 (preferably a flexible or elastic membrane) may cover the aperture 118. This may protect the conductive shielding 106 lining cavity 104 against corrosive impact and the cavity 104 against the intrusion of dirt. At the same time, an elastic or flexible property of the membrane 166 may allow a pressure exchange between an interior and an exterior of the cavity 104. In the absence of a membrane, exposed metallic surfaces (for example of the structures shown with reference signs 133 and 106) of the hollow volume inside component carrier 100 according to Figure 6 may be covered with a protection layer (not shown). Such a protection layer may provide a protection against corrosion and can be advantageously made of an electrically conductive material (such as nickel, gold or silver). Alternatively, such surfaces may be covered with a thin glass layer. In other embodiments with an open cavity 104 (see Figure 1), a membrane 166 or a protection layer may be provided as well.

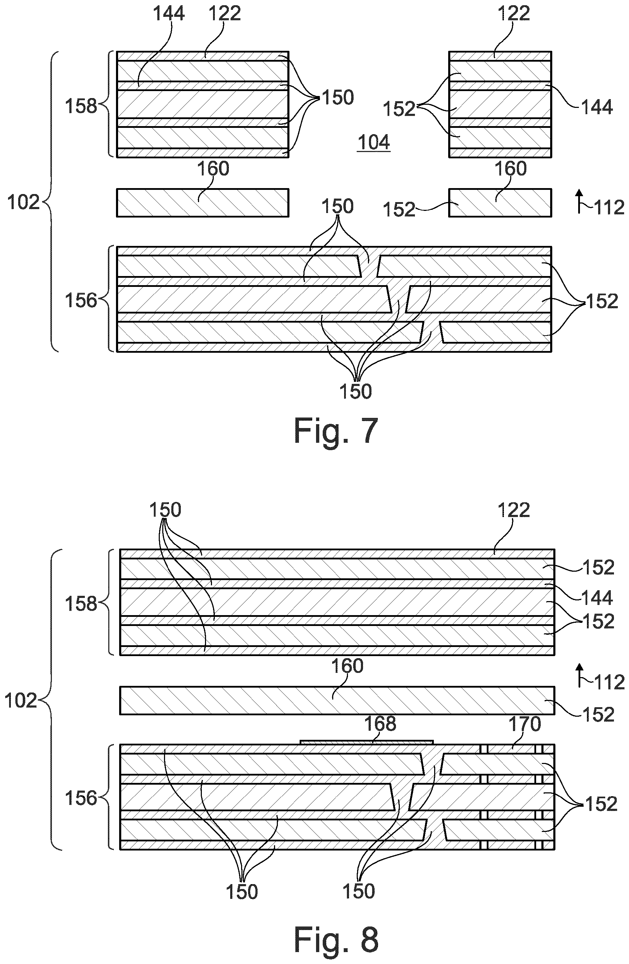

Figure 7 to Figure 9 illustrate cross-sectional views of structures obtained during carrying out a method of manufacturing a component carrier 100 according to an exemplary embodiment of the invention.

Referring to **Figure 7****,** a sequence of partially still unconnected layer structures is shown which can be used as a basis for forming a stack 102 for the embodiments of Figure 1 to Figure 6. As shown in Figure 7, stack 102 may be composed of a symmetrical lower sub-stack 156 and a symmetrical upper sub-stack 158, with a connecting low flow or no flow prepreg layer 160 in between. A symmetrical build-up may be preferred for suppressing warpage. However, an asymmetric sub-stack can also be used for forming the full stack. According to Figure 7, layer structures 150, 152 of the upper sub-stack 158 and of the low flow or no flow prepreg layer 160 are pre-cut for pre-defining cavity 104.

Generally, a prepreg material may be at least partially uncured before lamination and may become flowable during lamination (i.e. the application of pressure and/or heat), before being permanently hardened. However, this process may also lead to undesired flow of flowable resin into undesired regions of a component carrier under construction. Advantageously, when using a low flow or no flow prepreg layer 160, such an undesired resin flow may be reduced or even fully prevented thanks to the chemical composition of such a low flow or no flow prepreg layer 160.

After laminating lower sub-stack 156 (formed of continuous layer structures 150, 152), upper sub-stack 158 and connecting low flow or no flow prepreg layer 160 together, cavity 104 can be obtained.

Referring to **Figure 8****,** the layer structures 150, 152 of each of the lower sub-stack 156, the upper sub-stack 158 and the connecting no flow prepreg layer 160 (or alternatively a layer of ordinary prepreg) are continuous (i.e. may be not pre-cut). However, a poorly adhesive layer 168, which may also be denoted as release layer, is formed on a portion of the top side of the lower sub-stack 156. Optionally, one or more overlay fiducials 170 may be provided, for instance for alignment purposes. The dimension of the poorly adhesive layer 168 may correspond to a horizontal extension of the cavity 104 to be formed. After laminating lower sub-stack 156 with poorly adhesive layer 168 thereon, upper sub-stack 158 and connecting low flow or no flow prepreg layer 160 together, a laser beam or a mechanical means may circumferentially cut out a piece of stack material above the poorly adhesive layer 168. In view of the poorly adhesive property of the poorly adhesive layer 168, the piece can then be taken out from the stack 102, and cavity 104 can be obtained. The exposed poorly adhesive layer 168 can then be removed, for instance by stripping.

Referring to **Figure 9****,** a stack 102 with cavity 104 is shown which can be obtained for instance by carrying out the manufacturing processes of Figure 7 or Figure 8. Furthermore, an exposed surface of the cavity 104, apart from opening 132, may be coated with conductive shielding 106 to obtain the structure shown in Figure 9. For example, this can be accomplished by plating or sputtering.

Furthermore, one or more drill holes 172, 174 can be formed in the stack 102. For instance, drill hole 172 may be formed by a local mechanical drilling process. For example, drill hole 174 may be obtained by a global X-ray drilling process.

**Figure 10** illustrates a three-dimensional view of a component carrier 100 according to an exemplary embodiment of the invention. The embodiment of Figure 10 can be realized as a design with slot antennas 108', as described above referring to Figure 1 or Figure 2. In the illustrated embodiment, four slot antennas 108' are formed. However, any other number of slot antennas 108' may be formed in a component carrier 100, depending on the requirements of a certain application. For example, a length L to width W ratio L/W of the slots may be at least two, for example at least four. For example, the length L may be in a range from 1 mm to 5 mm. For instance, the width W may be in a range from 100 µm to 1 mm. In an example, the length L to width W ratio L/W of all slots may be the same. Alternatively, each ratio may be different to the other ratio(s). Additionally and/or alternatively, the embodiments of Figure 10 can be realized as a design with openings 110, as described above referring to Figure 4. Thereby, the opening(s) 110 may have the function of coupling slots and/or (part of) a filter.

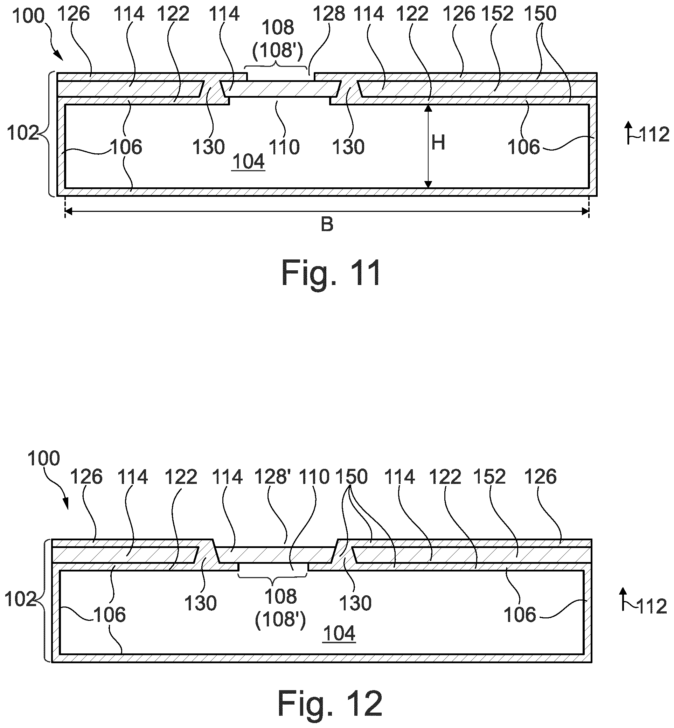

**Figure 11** illustrates a cross-sectional view of a component carrier 100 according to another exemplary embodiment of the invention.

As shown in Figure 11, uppermost electrically conductive layer structure 126, which is provided above the opening 110 of the conductive shielding 106, and a neighbouring electrically conductive layer structure 122 below are connected with each other by vertical through connections 130, which are here embodied as copper filled laser vias.

For example, the vertical through connections 130 may have a maximum diameter in a range from 20 µm to 250 µm, preferably in a range from 50 µm to 150 µm. Furthermore, the vertical through connections 130 may be distanced from each other by a mutual spacing in a range from 50 µm to 500 µm (wherein said mutual spacing may relate to a center to center distance between adjacent vertical through connections 130 in a top view of the component carrier 100). Furthermore, the vertical through connections 130 may be distanced from the functional opening 128 of the antenna structure in a range from 20 µm to 200 µm (in particular regarding the closest point between the edge of the antenna structure 128 and the vertical through connection 130). Furthermore, the tapering of the vertical through connections 130 may face from inside of the stack 102 to the outside of the stack 102, and vice versa. Alternatively, a closed conductive structure (i.e. of made of copper) may circumferentially fully surround the antenna structure 128. Further alternatively, an opened conductive structure may partially surround the antenna structure 128; said opened conductive structure may comprise a circumferential structure preferably divided at one point defining a space between two consequent extremities; alternatively, a plurality of sub-structures may be provided spaced one to each other around the antenna structure 128. The space between the two extremities or two adjacent sub-structures may preferably be at least 5 µm from each other in one direction perpendicular to stack direction 112. The conductive structure or the conductive sub-structures may have a straight shape, for example like an "I" or "L" and/or tapered sidewalls. In other words, the circumferential structure may be arranged as a cage having small portions free from conductive material. The described alternatives above may reduce signal losses.

The plurality of vertical through connections 130 are placed around a functional opening 128 in the uppermost electrically conductive layer structure 126 contributing to the formation of a slot antenna 108' configuration of said antenna 108. Thus, in Figure 11, functional opening 128 which is spatially separated from cavity 104 by a closed electrically insulating closure structure 114 acts as slot defining properties of slot antenna 108', i.e. acts as part of antenna 108'. The upper part of conductive shielding 106 according to Figure 11 with opening 110 (being larger than functional aperture 128) functions as transition opening layer, leading to relaxed alignment. Functional aperture 128 (being smaller than opening 110) functions as radiating element in Figure 11 and thereby forms the slot antenna 108'

Furthermore, Figure 11 indicates a height H and a width B of the cavity 104. The present inventors have found that height H and width B of the cavity 104 are meaningful design parameters for adjusting performance properties of the component carrier 100. Thus, appropriately dimensioning height H and width B may have a functional impact on bandwidth and/or return loss. More specifically, it has been found that decreasing a ratio between height H and width B of the cavity 104 can improve the bandwidth, so that said decrease of ratio H/B may be carried out until a bandwidth of electromagnetic wave transmission meets a predefined bandwidth criterion (for instance until a target bandwidth has been obtained). Additionally or alternatively, it has been found that increasing the ratio between height H and width B of the cavity 104 can reduce the return loss, so that said increase of ratio H/B may be carried out until the return loss of electromagnetic wave transmission meets a predefined return loss criterion (for instance until a target return loss has been obtained).

In the embodiment of Figure 11, the horizontal width B of the cavity 104 is greater than the vertical height H of the cavity 104. For example, said width B may be selected at least twice, in particular at least four times, of said height H.

It is also possible that the dimensions H, B of the cavity 104 are configured for setting a target frequency, for instance of at least 75 GHz. In such a scenario, an appropriate choice may be that the cavity 104 has a width B of less than 3 mm and a height H of less than 1.5 mm.

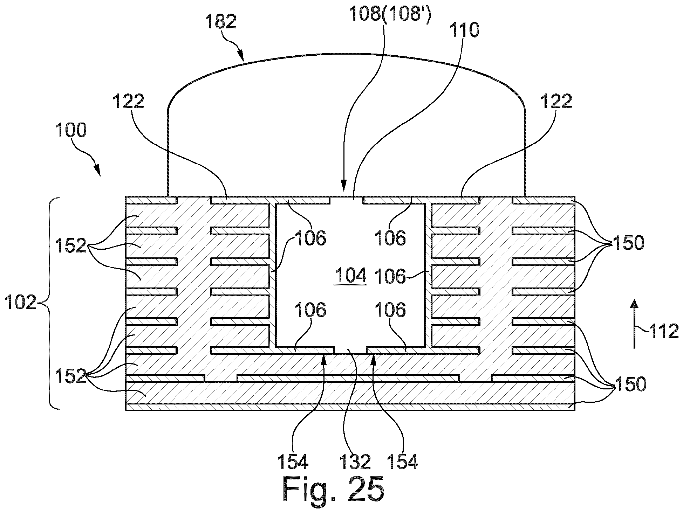

Although not shown in Figure 11, a lens may be located on top of the stack 102 and above the antenna 108. This may increase the directivity of the emitted signal. This is shown in Figure 25.

**Figure 12** illustrates a cross-sectional view of a component carrier 100 according to another exemplary embodiment of the invention.

The embodiment of Figure 12 differs from the embodiment of Figure 11 in particular in that, according to Figure 12, opening 128' which is spatially separated from cavity 104 by closed electrically insulating closure structure 114 is larger than opening 110 in conductive shielding 106. Hence, opening 110 acts as slot defining properties of slot antenna 108' of Figure 12, i.e. acts as part of antenna 108'. According to Figure 12, opening 110 is smaller than aperture 128', so that opening 110 fulfils the slot antenna functionality and prevents a reduction of loss by functioning as a fence which keeps the signal inside.

Referring to both embodiments of Figure 11 and Figure 12, the connection of the two uppermost electrically conductive layer structures 122, 126 by vertical through connections 130 may prevent a floating potential, which may have an additional positive impact on signal loss and signal integrity.

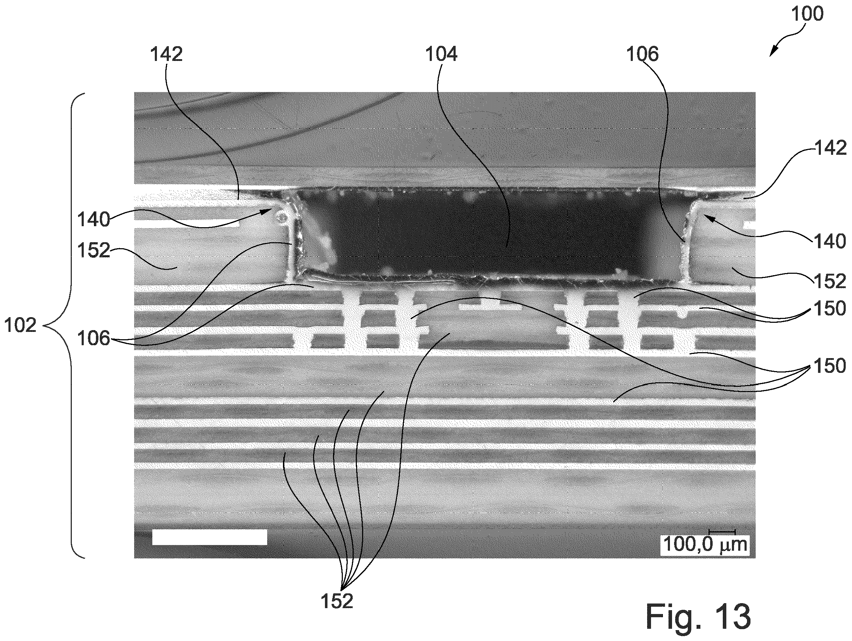

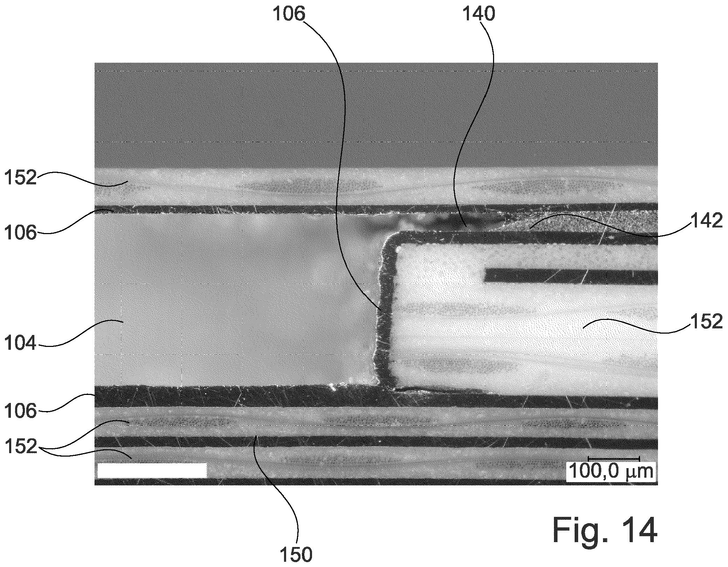

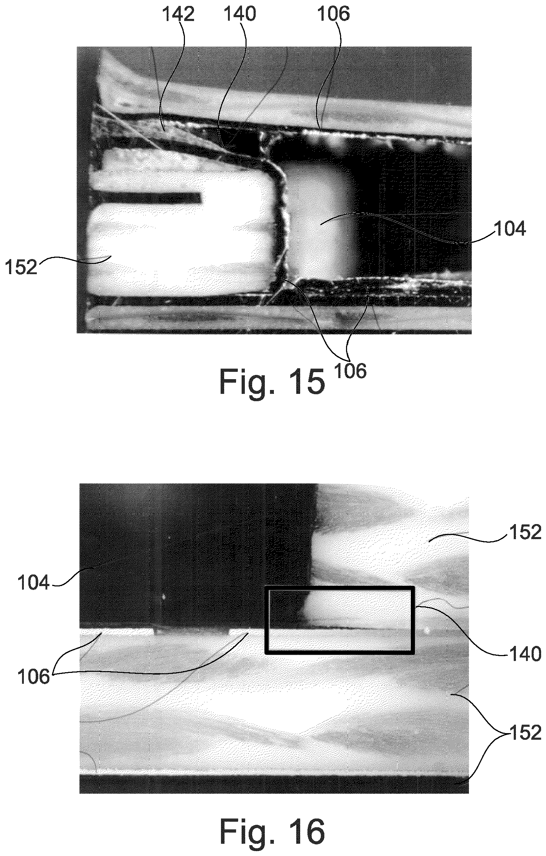

**Figure 13 to Figure 16** each illustrates a cross-sectional image of a component carrier 100 or part thereof according to an exemplary embodiment of the invention. A stepped edge 140 is shown at the top extremity of the cavity 104 (see Figure 13 to Figure 15) or at the bottom extremity of the cavity 104 (see Figure 16). A conductive connection medium 142 (such as a sinter structure) around a circumference enclosing the top extremity of cavity 104. This will be described in further detail referring to Figure 17.

**Figure 17** illustrates a three-dimensional view (left-hand side) and a cross-sectional view (right-hand side) of a conductive shielding 106 around a cavity 104 of component carrier 100 according to another exemplary embodiment of the invention.

As shown, the cavity 104 has a stepped edge 140 enlarging an extension of said cavity 104. Said stepped edge 140 is provided at the top extremity of the cavity 104 (but may be provided, additionally or alternatively, at the bottom extremity of the cavity 104 in other embodiments). The stepped edge 140 is covered by the conductive shielding 106. A width C from an end of the stepped edge 140 to an opposing end of the cavity 104 minus an average width (which may be the arithmetic average over the vertical extension of the cavity 104) of the cavity 104 divided by the average width of the cavity 104 may be in a range from 0.1% to 10%, for instance may be 1%. For example, a lateral extension 146 of the cavity 104 at the stepped edge 140 may have a maximum distance D of not more than 250 µm, in particular of not more than 100 µm. Although not shown in Figure 17, the lateral extension 146 of the stepped edge 140 may be delimited at least partially by the conductive connection medium 142 shown in Figure 13 to Figure 15. Preferably, the conductive connection medium 142 may have a wedge like shape.

**Figure 18** shows a diagram 200 indicating return loss RL (plotted in dB along an ordinate 204) over frequency f (plotted in GHz along an abscissa 202) of a component carrier 100 according to an exemplary embodiment of the invention.

Lines 206 indicate a required bandwidth at a frequency of 4 GHz. Line 208 indicates a margin of 1 GHz on each side. An impedance bandwidth 210 may be -10 dB. It can be derived from Figure 18 that the shown configuration of cavity 104 and conductive shielding 106 leads to a relatively narrow bandwidth. As indicated by arrows 212, manufacturing tolerances may lead to a shift in bandwidth. The cavity design of Figure 18 is based on cavity dimensions B=3.1 mm and H=1.55mm.

**Figure 19** shows a diagram 220 indicating return loss PL (plotted in dB along ordinate 204) over frequency f (plotted in GHz along abscissa 202) of a component carrier 100 according to an exemplary embodiment of the invention. The cavity design of Figure 19 is based on B=3.1 mm and H=0.5mm.

As shown in Figure 19, the slotted waveguide antenna with reduced height achieves a wider impedance matching. A wave impedance closer to that in air may be obtained which covers the full bandwidth (-10 dB).

**Figure 20** shows a diagram 230 indicating insertion loss IL (plotted in dB along an ordinate 234) over frequency (plotted in GHz along abscissa 202) of a component carrier 100 according to an exemplary embodiment of the invention. Various curves are shown for different values of the copper roughness "r" (which corresponds to the Ra value) of conductive shielding 106. As shown, low roughness leads to low insertion loss.

**Figure 21** shows a diagram 240 indicating phase shift PS (plotted in deg/cm along an ordinate 244) over frequency (plotted in GHz along abscissa 202) of a component carrier 100 according to an exemplary embodiment of the invention. Various curves are shown for different values of the copper roughness "r" (which corresponds to the Ra value) of conductive shielding 106. As shown, low roughness leads to low phase shift.

**Figure 22** shows a diagram 250 indicating loss LO (plotted in dB along an ordinate 254) over roughness Ra (plotted in µm along an abscissa 252) of a component carrier 100 according to an exemplary embodiment of the invention. A target loss is plotted by reference sign 256. As shown, a lower loss may be obtained with a lower roughness.

**Figure 23** illustrates a cross-sectional view of a component carrier 100 according to another exemplary embodiment of the invention. **Figure 24** illustrates a top view of the component carrier 100 according to Figure 23. This embodiment implements a radiofrequency filtering effect. More specifically, the illustrated component carrier 100 comprises a radiofrequency filtering structure 180 configured as a top portion of the stack 102. The illustrated radiofrequency filtering structure 180 is formed by patterned metal layers, such as one or more of the electrically conductive layer structures 122, 126, 152 connected with each other by vertical through connections 130. Alternatively, the filtering structure 180 may be free from vertical through connections 130. The design, in particular the amount of electrically conductive layer structure and/or the location of the vertical through connections, may impact the filter efficiency of the filtering structure 180. Moreover, the filtering structure may be able to filter one and/or at least two frequencies.

**Figure 25** illustrates a cross-sectional view of a component carrier 100 according to another exemplary embodiment of the invention. This embodiment implements a lens. More specifically, the illustrated component carrier 100 comprises a radiofrequency lens component 182 being surface mounted on top of the stack 102. Since a radiofrequency lens component 182 may have significant dimensions for providing a powerful focusing of radiofrequency waves, it may be preferred to surface mount the radiofrequency lens component 182 onto a top main surface of the stack 102. Preferably, the lens component 182 is located such that it may cover the antenna 108 and/or the functional opening 128. This may bring the advantage of physically and/or chemically sealing and/or protecting the antenna 108 and/or the functional opening 128. The elongation of the lens component 182 in direction perpendicular to stack direction 112 may be larger than the antenna 108 and/or the functional opening 128 and/or cavity 104.

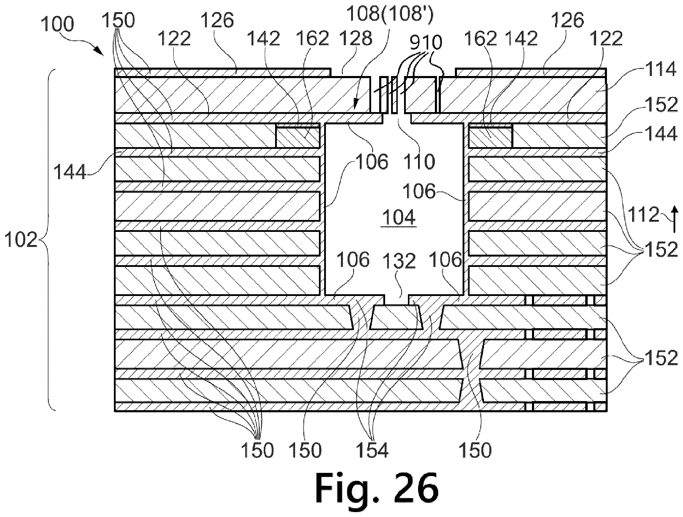

**Figure 26** illustrates a cross-sectional view of a component carrier 100 according to another exemplary embodiment of the invention.

The embodiment of Figure 26 differs from the embodiment of Figure 2 in particular in that, according to Figure 26, the electrically insulating layer closure structure (114) comprises a plurality of through holes (910). Alternatively, one through hole (910) may be provided in the electrically insulating layer closure structure (114). Preferably, the through holes (910) may extend along the stack direction (112). The through holes (910) may have an extension, for example a diameter, perpendicular to the stack direction (112) smaller than 25 µm, in particular in the range between 400 nm to 20 µm, more in particular in the range between 500 nm to 15 µm. Alternatively, the through holes (910) may have an extension perpendicular to stack direction (112) in the range between 25 µm to 40 µm. The through holes (910) may have an elongated shape, for example like a tube. In an example the through holes (910) may have a shape having vertically straight sidewalls, for example a cylinder. In another example, the through holes (910) may have a shape having tapered sidewalls, for example a frustoconical shape or an irregular shape. Preferably, the through holes (910) may be created by a subtractive manufacturing process step, for example plasma etching or reactive ion etching. Subtractive process steps are well known in printed circuit board manufacturing. Therefore, through holes (910) having an elongated shape may be manufactured with low effort using a subtractive process step. Preferably, the one or the plurality of through holes (910) may be provided in said electrically insulating layer closure structure (114) being thereby connected to the opening (110) of the conductive shielding (106). Additionally or alternatively, the one or the plurality of through holes (910) may be provided in said electrically insulating layer closure structure (114) being connected to one of the plurality of electrically conductive layer structures (150). In an example, the one or the plurality of through holes (910) may be provided in said electrically insulating layer closure structure (114) being connected to the aperture (116) (not shown). In a further example, the through holes (910) may be filled with gas, for example air or nitrogen. Alternatively, the through holes (910) may be filled with a material having a dielectric constant smaller than 3, in particular smaller than 1.5, for example carbon black, silicon dioxide, or isobutyl resin. Filling the through holes (910) with a material having a dielectric constant smaller than 3 may bring the advantage that a propagation of an electromagnetic wave between the cavity (104) and the antenna (108) undergoes low losses. In an example, one extremity of the respective one or respective plurality of through holes (910) may be connected to the environment, whereas the opposite other extremity of the respective one or respective plurality of through holes (910) may be connected to the opening (110) of the conductive shielding (106) and/or an electrically conductive layer structure (150). According to an embodiment of the invention, the electrically insulating layer closure structure (114) may comprise or consist of a material being different from the material of the other electrically insulating layer structures (152) belonging to the stack. In particular, the electrically insulating layer closure structure (114) may have a dielectric constant being smaller than the dielectric constant of the other electrically insulating layer structures (152). In an example, the dielectric constant of the electrically insulating layer closure structure (114) may have a value being smaller than 3.7, in particular in the range from 1.5 to 3.5, more in particular in the range between 1.9 to 3.3. Additionally or alternatively, the electrically insulating layer closure structure (114) may have a dissipation factor (Df) smaller than 0.005, in particular smaller than 0.003. The thickness of the electrically insulating layer closure structure (114) may be smaller than 100 µm, in particular in the range between 15 µm to 70 µm. Since the electrically insulating layer closure structure (114) may have preferred physical properties regarding electromagnetic wave propagation (small Dk- and/or Df- value), the losses of the transmission of the electromagnetic waves between the opening (110) of the conductive shielding (106) and the functional opening (128) may be small even if the thickness of the electrically insulating layer closure structure (114) is in the range between 15 µm to 100 µm. Alternatively, as shown in Figure 2, the electrically insulating closure structure (114) may comprise same or similar material as the other electrically insulating layer structures (152). Preferably, when the electrically insulating layer closure structure (114) comprises similar or same material as the other electrically insulating layer structures (152), the thickness of the electrically insulating layer closure structure (114) may be smaller than 50 µm, in particular in the range between 10 µm to 35 µm. Thereby, when the electrically insulating layer closure structure (114) comprises similar or same material as the other electrically insulating layer structures (152), the material may have a dielectric constant in the range between 3.8 to 4.5 and/or may have a dissipation factor larger than 0.007, in particular in the range between 0.009 to 0.015. Preferably, the through holes (910) may be located in the area of the opening (110) or the functional opening (128), in particular in the intersection of the areas of the opening (110) and the functional opening (128), when considering a top view. Alternatively, the through holes (910) may be located outside the area of the opening (110) and/or the functional opening (128), when considering a top view.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. Component carrier (100), wherein the component carrier (100) comprises:
a stack (102) comprising a plurality of electrically conductive layer structures (150) and a plurality of electrically insulating layer structures (152);
a cavity (104) formed in the stack (102), said cavity (104) being delimited by a peripheral wall;
a conductive shielding (106) covering the peripheral wall of the cavity (104); and
an antenna (108) formed as part of said stack (102);
wherein the conductive shielding (106) has an opening (110) on a top extremity of said cavity (104) along a stack direction (112), said opening (110) being vertically associated with the antenna (108) provided on top of and/or at said opening (110).

2. The component carrier (100) according to claim 1, wherein the stack (102) comprises an electrically insulating layer closure structure (114) provided on the top extremity of the cavity (104).

3. The component carrier (100) according to claim 2, wherein said electrically insulating layer closure structure (114) covers the opening (110) of the conductive shielding (106).

4. The component carrier (100) according to claim 2 or 3, wherein said electrically insulating layer closure structure (114) comprises a material different from the materials of the other electrically insulating layer structures (152).

5. The component carrier (100) according to claim 3 or 4, wherein one or a plurality of through holes (910) are provided in said electrically insulating layer closure structure (114), in particular connected to the opening (110) of the conductive shielding (106).

6. The component carrier (100) according to any of claims 1 to 5, wherein the stack (102) comprises, on top of a stack portion defining the cavity (104), an electrically conductive layer structure (122), in particular said electrically conductive layer structure (122) is provided between said stack portion and the electrically insulating layer closure structure (114).

7. The component carrier (100) according to any of claims 6, wherein the stack (102) comprises a further electrically conductive layer structure (124) between the insulating layer closure structure (114) and the at least one further electrically insulating layer structure (120).

8. The component carrier (100) according to any of claims 1 to 7, wherein one of the plurality of electrically conductive layer structures (126), which is provided above the opening (110) of the conductive shielding (106), has a functional opening (128) contributing to the formation of a slot antenna (108') configuration of said antenna (108).

9. The component carrier (100) according to claims 8, wherein one or a plurality of through holes are configured to connect the functional opening (128) with the opening (110) vertically associated with the antenna (108).

10. The component carrier (100) according to any of claims 1 to 9, wherein one of the plurality of electrically conductive layer structures (126), which is provided above the opening (110) of the conductive shielding (106), and a neighbouring of the electrically conductive layer structures (122) are connected with each other by at least one vertical through connection (130), in particular by a plurality of vertical through connections (130) placed around a functional opening (128) contributing to the formation of a slot antenna (108') configuration of said antenna (108).

11. The component carrier (100) according to any of claims 8 to 10, wherein the opening (110) is a slot and the functional opening (128) is a further slot, wherein optionally the slot and the further slot are inclined relatively to each other in a top view on the stack (102).

12. The component carrier (100) according to any of claims 1 to 11, wherein the conductive shielding (106) comprises a further opening (132) on a bottom extremity of said cavity (104) along the stack direction (112).

13. The component carrier (100) according to claim 12, wherein the opening (110) is a slot and the further opening (132) is another slot, wherein optionally the slot and the other slot are inclined relatively to each other in a top view on the stack (102).

14. The component carrier (100) according to any of claims 1 to 13, wherein the cavity (104) has a stepped edge (140) enlarging an extension of said cavity (104).

15. The component carrier (100) according to any of claims 1 to 14, comprising a conductive connection medium (142) around a circumference of the cavity (104), in particular around a circumference enclosing the top extremity of said cavity (104), said conductive connection medium (142) being in particular made of a solder structure or a sinter structure.
